# EUROPÄISCHE PATENTSCHRIFT

(11) **EP 1 925 577 B1**
(45) Veröffentlichungstag und Bekanntmachung des Hinweises auf die Patenterteilung: **08.07.2009**
(21) Anmeldenummer: 06077093.0
(22) Anmeldetag: 24.11.2006
(51) Int. Cl.: B65G 49/06, H01L 21/00, H01L 21/677, H01L 21/68, H01L 21/683

(54) **Verfahren zum Bilden einer in einem Prozessboot zu positionierenden Back-to-Back Wafercharge und Handhabungssystem zum Bilden der Back-to-Back Wafercharge**
Method for forming a back-to-back wafer batch to be positioned in a process boat and handling system for forming the back-to-back wafer batch
Procédé pour former des groupes de tranches de silicium dos à dos, à charger dans une nacelle et système de manipulation pour former des groupes de tranches de silicium dos à dos

(43) Veröffentlichungstag der Anmeldung: 28.05.2008
(73) Patentinhaber: Jonas & Redmann Automationstechnik GmbH, 10553 Berlin (DE)
(72) Erfinder: Jonas, Stefan, 12351 Berlin (DE); Redmann, Lutz, 14532 Kleinmachnow (DE)
(74) Vertreter: Hoffmann, Klaus-Dieter

(56) Entgegenhaltungen:
- JP-A- 7 307 319
- JP-A- 2001 093 959
- JP-B- 6 030 373
- US-A- 4 840 530
- US-A- 4 856 957
- US-A- 4 987 407

## Beschreibung

Die Erfindung betrifft ein Verfahren zum Bilden einer in einem Prozeßboot zu positionierenden, paketmäßigen Back-To-Back-Wafercharge (BTB-Wafercharge), die aus einer vorbestimmten geraden Anzahl reihenmäßig angeordneter und einseitig zu dotierender Wafer wie Solarwafer besteht, deren nicht zu dotierende Seite jeweils an der nicht zu dotierenden Seite des entsprechenden benachbarten Wafers deckungsgleich angelegt ist, wobei die erste und die zweite Hälfte der vorbestimmten geraden Anzahl Wafer jeweils mittels eines Carrier%, der mit nach oben weisenden Aufnahmeschlitzen in einer waagerechten Ebene festgespannt wird, in einer Bereitstellungsposition bereitgestellt und nacheinander in Form eines ersten bzw. eines zweiten Waferstapels aus dem Carrier mittels in vertikaler Richtung verfahrbarer Aushebekämme, die jeweils unterhalb des Carriers zu positionieren sind, herausbewegt und in einer gemeinsamen Aushebeposition, in der die Wafer des ersten Waferstapels und des zweiten Waferstapels jeweils zueinander um 180° versetzt sind, nacheinander positioniert und zueinander ausgerichtet werden und der zweite Waferstapel mit dem ersten Waferstapel formschlüssig zu der paketmäßigen Back-To-Back-Wafercharge (BTB-Wafercharge) zusammengefügt wird, indem jeweils die nicht zu dotierenden Seiten der einander zugeordneten Wafer des ersten und des zweiten Waferstapels gleichzeitig deckungsgleich aneinander gelegt werden, worauf die BTB-Wafercharge von einem Transfergreifer formschlüssig übernommen und an einer Einlegeposition des Prozeßbootes abgelegt wird.

Die Erfindung betrifft auch ein alternatives Verfahren zum Bilden einer in einem Prozeßboot zu positionierenden paketmäßigen Back-To-Back-Wafercharge (BTB-Wafercharge), die aus einer vorbestimmten geraden Anzahl reihenmäßig angeordneter und einseitig zu dotierender Wafer wie Solarwafer besteht, deren nicht zu dotierende Seite jeweils an der nicht zu dotierenden Seite des entsprechenden benachbarten Wafers deckungsgleich anliegt, wobei die vorbestimmte Anzahl der einseitig zu dotierenden Wafer in den Aufnahmeschlitzen eines Carriers reihenmäßig bereitgestellt wird, der in einer waagerechten Ebene mit nach oben weisenden Aufnahmeschlitzen festgespannt wird, eine Hälfte der vorbestimmten geraden Anzahl Wafer für die zu bildende BTB-Wafercharge aus dem Carrier bewegt und in Form eines ersten Waferstapels mittels einer Transfereinrichtung zu dem Prozeßboot überführt und in dessen Aufnahmeschlitzen in einer Einlegeposition positioniert wird, dann die andere Hälfte der vorbestimmten Anzahl Wafer für die zu bildende BTB-Wafercharge aus dem Carrier bewegt und in Form eines zweiten Waferstapels, dessen Wafer zuvor um 180° in Bezug auf die Lage der Wafer des ersten Waferstapels in der Einlegeposition des Prozeßbootes versetzt worden sind, von der Transfereinrichtung zu dem Prozeßboot überführt, oberhalb in Ausrichtung zu den in der Einlegeposition des ersten Waferstapels im Prozeßboot befindlichen Wafern um einen Abstand der Einlegeposition versetzt positioniert wird, der mindestens so groß wie die Waferdicke ist, und dann mit dem in der Einlegeposition des Prozeßbootes positionierten ersten Waferstapel zusammengefügt wird, indem jeweils die nicht zu dotierenden Seiten der einander zugeordneten Wafer des ersten und des zweiten Waferstapels gleichzeitig deckungsgleich aneinander gelegt werden.

Die Erfindung betrifft weiterhin ein Handhabungssystem zum Beschicken eines mehrere Einlegepositionen aufweisenden Prozeßbootes mit Waferchargen vor der Dotierung in einem Diffusionsofen, mit einer automatischen Transferanlage, von der ein mit einer vorbestimmten Anzahl Wafer bestückter Carrier in einer waagerechten Transportebene in eine Bereitstellungsposition zur Bildung von Waferstapeln zu bewegen ist, mit einem Spannmodul, von dem der Carrier mit nach oben weisenden Aufnahmeschlitzen in der Bereitstellungsposition derart ausgerichtet festzuhalten ist, dass die Mitten der in den Aufnahmeschlitzen des Carriers befindlichen Wafer exakt zu den Kammlücken von in vertikaler Richtung verfahrbaren Aushebekämmen eines ersten und eines zweiten Vertikal-Achsmoduls ausgerichtet sind, die jeweils fest unterhalb des Spannmoduls in der Bereitstellungsposition angeordnet sind, wobei von dem Aushebekamm des ersten Vertikal-Achsmoduls die erste Hälfte der vorbestimmten Anzahl der Wafer in dem vom Spannmodul gehaltenen Carrier als erster Waferstapel nach oben in eine erste Aushebeposition zu bewegen und in dieser mittels einer Dreheinrichtung in einer um 180° versetzte Lage in Bezug auf seiner Lage in der Bereitstellungsposition in dem Aushebekamm des ersten Vertikal-Achsmoduls vorzusehen und der Aushebekamm wieder runterzufahren ist, anschließend von dem Aushebekamm des zweiten Vertikal-Achsmoduls die zweite Hälfte der Anzahl der in den Aufnahmeschlitzen des Carriers befindlichen Wafer als zweiter Waferstapel in eine zweite Aushebepostion anzuheben ist, dann der zweite Waferstapel ohne Drehung in die erste Aushebeposition oberhalb des ersten Waferstapels zu bewegen ist, in die der erste Waferstapel von dem Aushebekamm des ersten Vertikal-Achsmoduls hochzufahren und in den zweiten Waferstapel einzufügen ist und die Wafer des ersten und des zweiten Waferstapels Rücken an Rücken unter Bildung einer paketmäßigen BTB-Wafercharge mit verdoppelter Dotierungsfläche im Aushebekamm des ersten Vertikal-achsmoduls anzulegen sind, und mit einem Transfergreifer, von dem die gebildete BTB-Wafercharge von der ersten Aushebeposition zum Prozeßboot zu bewegen und an einer der Einlegepositionen abzulegen ist.

Bei einem aus der US 4 856 957 A bekannten Verfahren der eingangs genannten Art finden zum Bilden einer BTB-Wafercharge aus Halbleiterwafern zwei Carrier Verwendung, in denen jeweils eine Hälfte der Anzahl der einseitig zu dotierenden Wafer der zu bildenden BTB-Wafercharge reihenmäßig bereitgestellt wird, wobei bereits beim aufeinanderfolgenden Bereitstellen jeder Hälfte der Wafer in dem jeweiligen Carrier in einer Bereitstellungsstation eine um 180° versetzte Ausrichtung der Wafer in dem einen Carrier in Bezug auf die Ausrichtung der Wafer in dem anderen Carrier gegeben ist. Weiterhin werden die erste und die zweite Hälfte der Wafer in Form des ersten bzw. zweiten Waferstapels mittels der in vertikaler Richtung verfahrbaren Aushebekämme nacheinander in nur eine gemeinsame Aushebeposition überführt, in dieser zueinander ausgerichtet und zu der paketmäßigen BTB-Wafercharge formschlüssig zusammengefügt.

Bekannt ist aus der US 4 840 530 A auch ein alternatives Verfahren der oben erwähnten Art zum Bilden einer in einem Prozeßboot zu positionierenden paketmäßigen Back-To-Back-Wafercharge (BTB-Wafercharge) aus Halbleiterwafern, bei dem zunächst eine Hälfte der vorbestimmten Anzahl Wafer des in einer Bereitstellungsstation angeordneten Carrier aus diesem mittels eines Aushebekamms herausgehoben und von diesem in Form des ersten Waferstapels zu einer in einer Aushebeposition positionierten Halteeinrichtung überführt wird, von der der erste Waferstapel übernommen und in die Einlegeposition des Prozeßbootes überführt wird. Der Aushebekamm wird dann aus der Aushebeposition in die Bereitstellungsstation zurückgefahren, in der der Carrier, in dem die zweite Hälfte der vorbestimmten Anzahl Wafer noch vorgesehen ist, dann mittels eines um 180° um eine vertikale Achse drehbaren Drehtisches gedreht wird. Hierdurch wird die zweite Hälfte der vorbestimmten Anzahl Wafer in der Bereitstellungsstation in die um 180° versetzte Lage in Bezug auf die Lage der Wafer des bereits in die Einlegeposition des Proßeßbootes überführen ersten Waferstapels versetzt. Die zweite Hälfte der vorbestimmten Anzahl Wafer wird dann in Form des zweiten Waferstapels von dem Aushebekamm aus dem Carrier heraus zu der in die Aushebeposition rückgeführten Halteeinrichtung überführt, von dieser übernommen, zum Prozeßboot überführt und ausgerichtet in Bezug auf den ersten Waferstapel mit diesem in der Einlegeposition des Prozeßbootes zusammengefügt.

Bekannt ist ferner ein Handhabungssystem der oben erwähnten Art zum Beschicken eines mehrere Einlegepositionen aufweisenden Prozeßbootes mit Waferchargen vor der Dotierung in einem Diffusionsofen (JP 6 30373 B und JP 63 84043 A), bei dem zu Bilden der Back-To-Back-Wafercharge die Aushebekämme mit einer Dreheinrichtung kombiniert sind. Hier ist die erste Hälfte der vorbestimmten Anzahl Wafer von der Dreheinrichtung aus einem in einer Bereitstellungsstation zu positionierenden ersten Carrier heraus in die erste Aushebeposition in Form des ersten Waferstapels herauszuheben, in dieser von der Dreheinrichtung um 180° zu verdrehen und dann wieder in die Bereitstellungsstation zu verfahren. Anschließend ist die zweite Hälfte der vorbestimmten Anzahl Wafer in Form des zweiten Waferstapels aus einem zweiten Carrier, der in der Bereitstellungsstation zu positionieren ist, von einem mit der Dreheinrichtung kombinierten zweiten Aushebekamm herauszuheben und in der zweiten Aushebeposition in einer horizontal verfahrbaren Transfereinrichtung zu positionieren, von der der zweite Waferstapel aus der zweite Aushebeposition unverdreht in die erste Aushebeposition zu verfahren ist, in die dann der zuvor um 180° verdrehte und in der Bereitstellungsstation im ersten Carrier positionierte erste Waferstapel aus letzterem von dem ersten Aushebekamm herauszuheben und in dem zweiten Waferstapel in der ersten Aushebeposition einzufügen ist.

Schließlich sind ein Handlingsystem zum Be- und Entladen einer Prozeßanlage mit mindestens einem Carrier, der mit zumindest einem flachen Substrat für einen Vertikaltransport des Substrats be- und entladbar ist, und ein Verfahren zum Betrieb dieses Handlingsystems aus der DE 10 2004 039 787 grundsätzlich bekannt. Danach sind ein erstes und ein zweites Handlingmodul vorvorgesehen, wobei zumindest einem der Handlingmodule zumindest eine Substrat - Handlingeinheit für einen vom Carrier separaten Substrat-Transfer zugeordnet ist. Der Carrier ist mit dem vertikal ausgerichteten Substrat zwischen der Prozeßanlage und dem ersten Handlingmodul, der Prozeßanlage und dem zweiten Handlingmodul sowie zwischen den beiden Handlingmodulen transferierbar, und die Substrats-Handlingeinheit ist als Mehr-Achsen-Roboter, vorzugsweise mit einem oder mehreren Saugnapf-Greifern ausgebildet.

Für die Steigerung der Wirtschaftlichkeit des Produktionsprozesses von Solarzellen bildet die Automatisierung des Solarwafer-Handling, speziell der Be- und Entladevorgang des Prozeßbootes, mit dem die Solarwafer in den bzw. aus dem Diffusionsofen zu bringen sind, einen wichtigen Faktor. Der Diffusionsprozeß erfordert nur die Diffusion einer Seite des Wafers. Die Solarwafer werden dem Diffusionsofen in einem typischerweise mit 200 in der Vertikalen um 3° geneigten Aufnahmeschlitzen versehenen Prozeßboot zugeführt. Eine derartige Neigung der Aufnahmeschlitze bewirkt eine Vorausrichtung der Solarwafer, damit diese sich an die Flanken der Aufnahmeschlitze des Prozeßbootes anlegen.

Der Erfindung liegt die Aufgabe zugrunde, ein Verfahren und ein Handhabungssystem der eingangs erwähnten Art zur Verfügung zu stellen, mit dem zur Steigerung des Durchsatzes des Diffusionsprozesses und gleichzeitiger Verringerung der Ausschußrate für eine gleichzeitige Beschleunigung und Präzisierung der Transport-, Handhabungs- und Positionierungsvorgänge gesorgt werden kann.

Diese Aufgabe wird gemäß der Erfindung verfahrensmäßig dadurch gelöst, dass die erste Hälfte und die zweite Hälfte der vorbestimmten geraden Anzahl Wafer für die zu bildende BTB-Wafercharge in den Aufnahmeschlitzen nur eines einzigen Carriers reihenmäßig bereitgestellt werden, aus dem die Wafer in Form des ersten und des zweiten Waferstapels herausbewegt werden, wobei zunächst der erste Waferstapel in eine weitere Aushebeposition, die ungleich der gemeinsamen Aushebeposition ist, von dem ihm zugeordneten Aushebekamm gehoben, in dieser von einem in horizontaler Richtung zu verfahrenden Mehrfach-Vakuumgreifer eines BTB-Moduls über induktive Näherungsschalter gesteuert ergriffen, durch Rotation des Mehrfach-Vakuumgreifers um 180° um eben diesen Winkel zu seiner Lage in der Bereitstellungsposition verschwenkt und anschließend durch Verfahren des Mehrfach-Vakuumgreifers in horizontaler Richtung in dieser verschwenkten Lage in der gemeinsamen Aushebeposition positioniert wird, in der nach Überführung des zweiten Waferstapels mittels des ihm zugeordneten Aushebekamms in die gemeinsame Aushebeposition die Zusammenfügung des zweiten Waferstapels mit dem ersten Waferstapel erfolgt, indem die Wafer des zweiten Waferstapels jeweils entlang einer servogesteuerten Bewegungsbahn an den in der gemeinsamen Aushebeposition positionierten Wafern des ersten Waferstapels bis zur formschlüssigen Deckung vorbeibewegt und dann die Wafer des ersten Waferstapels zusammen mit den Wafern des zweiten Waferstapels Rücken an Rücken in dem dem zweiten Waferstapel zugeordneten Aushebekamm angelegt werden.

Die Aufgabe wird alternativ erfindungsgemäß dadurch gelöst, dass als Transfereinrichtung ein Mehrfach-Vakuumgreifer eines BTB-Moduls verwendet wird, von dem die erste und die zweite Hälfte der vorbestimmten Anzahl Wafer für die zu bildende BTB-Wafercharge nacheinander in Form des ersten bzw. des zweiten Waferstapels unmittelbar aus dem Carrier entnommen und nacheinander servogesteuert zu der Einlegeposition des Prozeßbootes überführt werden, wobei der vom Mehrfach-Vakuumgreifer aus dem Carrier entnommene zweite Waferstapel durch Rotation des Mehrfach-Vakuumgreifers bei der Überführung zum Prozeßboot in die um 180° versetzte Lage in Bezug auf die Lage des bereits in der Einlageposition des Prozeßbootes positionierten ersten Waferstapels verschwenkt wird.

Durch die mögliche unmittelbare Entnahme des ersten wie des zweiten Waferstapels nacheinander aus dem Carrier und die Verschwenkung der Wafer des zweiten Waferstapels um 180° in Bezug auf die Lage der Wafer des ersten Waferstapels durch Rotation des Mehrfach-Vakuumgreifers bei der Überführung zum Prozeßboot ist ein effizienter und kostensparender Verfahrensablauf gegeben.

Zudem sind alle Einlegepositionen mit je 50 Aufnahmeschlitzen des Prozeßbootes nacheinander in gleicher Weise zu beladen, so daß durch das erfindungsgemäße Back-To-Back-Prinzip mit 400 Solarwafern die doppelte Kapazität in einem gängigen Prozeßboot mit typischerweise 200 um 3° zur Vertikalen geneigten Aufnahmeschlitzen zu erzielen ist.

Durch die Aufnahme von jeweils zwei Rückseite an Rückseite (Back-To-Back) liegenden Wafern der BTB-Solarwafercharge in einem Aufnahmeschlitz des Prozeßbootes ist die Packungsdichte in diesem und damit auch der Durchsatz des Diffusionsofens zu verdoppeln.

Die Aufgabe der Erfindung wird weiterhin gelöst durch das eingangs genannte Handhabungssystem zum Bilden einer paketmäßigen Back-To-Back-Wafercharge (BTB-Wafercharge) aus einseitig zu dotierenden Wafer wie Solarwafer, das gekennzeichnet ist durch
- ein Back-To-Back-Modul (BTB-Modul), das einen oberhalb des Spannmoduls angeordneten und in eine X-Y-Z und R-Richtung verfahrbaren Mehrfach-Vakuumgreifer mit Sauggreifkämmen aufweist, der um seine vertikal gerichtete Achse von einem Servomotor über ein nachgeschaltetes spielfreies Getriebe in Drehung zu versetzen ist, und
- ein Zentriermodul, von dem die Anzahl der Wafer des aus dem Carrier in die erste bzw. zweite Aushebeposition gehobenen ersten bzw. zweiten Waferstapels an den seitlichen Kanten und mit exaktem Abstand der Wafer zu einander in dem ersten bzw. zweiten Waferstapel auszurichten ist,
- wobei der erste Waferstapel in der ersten Aushebeposition von dem Mehrfach-Vakuumgreifer des Back-To-Back-Moduls (BTB-Modul) über induktive Näherungsschalter gesteuert zu ergreifen, um den Winkel von 180° zu verschwenken und ohne Relativbewegung in Bezug auf den Aushebekamm des ersten Vertikal-Achsmoduls in diesem in der um 180° verschwenkten Lage in der ersten Aushebepostion wieder abzulegen und der Aushebekamm des ersten vertikal-achsmoduls wieder runterzufahren ist,
- anschließend der in die zweite Aushebeposition ausgehobene zweite Waferstapel von dem Mehrfach-Vakuumgreifer zu ergreifen und ohne Drehung in die erste Aushebeposition oberhalb des ersten Waferstapels zu bewegen ist, in der die Wafer des von dem Aushebekamm des ersten Vertikal-Achsmoduls hochzufahren den ersten waferstapels entlang einer servogesteuerten Bewegungsbahn an den zugeordneten Wafern des zweiten Waferstapels vorbeizubewegen und die Wafer des zweiten Waferstapels zusammen mit den Wafern des ersten Waferstapels Rücken an Rücken in dem hochgefahrenen Aushebekamm des ersten Vertikal-Achsmoduls anzulegen sind.

Durch den Rotationsantrieb des BTB-Moduls um seine vertikale achse mittels des Servomotors über das nachgeschaltete spielfreie Getriebe ist der vom Mehrfach-Vakuumgreifer anzusaugende erste Waferstapel mit genau definierten Anfahrt- und Bremsrampen in Drehung zu versetzen, wodurch ruckartige Schwenkbewegungen vermieden und die Ausschußrate vermindert werden. Die Steuerung der Schwenkbewegung über einen Servomotor ermöglicht ein exaktes, ruckfreies und damit für den Wafer stressfreies Anfahren der gewünschten Position. Die hierdurch verbesserte Möglichkeit einer Positionierung garantiert ein sehr genaues Ausheben und Wiedereinführen eines Waferstapels in einen Kamm, wobei Relativbewegungen zwischen Wafer und Kamm vermieden werden.

Vorteilhafterweise weist der Mehrfach-Vakuumgreifer des BTB-Moduls ein mit dessen vertikaler Achse verbundenes Oberteil und ein Sauggreifkämme aufnehmendes Unterteil auf, wobei das Oberteil und das Unterteil durch zwei Kugelumlaufführungselemente verbunden und von diesen während einer Bewegung präzise fluchtend gehalten sind. Am Oberteil des Mehrfach-Vakuumgreifers sind weiterhin zwei induktive Sensoren vorgesehen sind, von denen beim Absenken des Mehrfach-Vakuumgreifers ein Aufsetzen der Unterseite der Sauggreifkämme auf die oberen Stirnflächen der in einem Aushebekamm befindlichen Wafer zu erfassen und ein weiteres Absenken des Mehrfach-Vakuumgreifers mit minimaler Verzögerung zu sperren ist. Durch die verbesserte Ansprechzeit ist im Aufsetzfall somit nur eine geringe Krafteinwirkung auf die Solarwafer gegeben.

Vorzugsweise weist der Mehrfach-Vakuumgreifer zwei Sauggreifkämme mit jeweils 50 Kammwände auf, mit denen insgesamt 50 Solarwafer zu ergreifen sind. In dem Carrier sind daher 100 Solarwafer bereitzustellen, die von dem Aushebekamm des ersten und des zweiten Vertikal-Achsmoduls in Form des ersten bzw. des zweiten Waferstapels mit je 50 Wafern dem BTB-Modul zuzuführen sind, von dem der erste und der zweite Waferstapel zu der einpaketartigen BTB-Wafercharge mit 100 Rückseite an Rückseite liegenden Wafern zusammenzufügen sind. In einem aus Quartz bestehenden Prozeßboot können 4 Ladungsabteile vorgesehen werden, in denen jeweils eine paketmäßige BTB-Wafercharge mit 50 BTB-Wafern (100 Solarwafer) von einem Transfergreifer abzulegen ist.

Bevorzugt sind die Kammwände der Sauggreifkämme des Mehrfach-Vakuumgreifers, die die Aufnahmeschlitze jedes Sauggreifkamms begrenzen und mit den Seitenflächen der Wafer in Eingriff kommen, jeweils in Form einer rahmenmäßigen Einfassung mit zueinander parallelen und horizontal verlaufenden Lamellen gestaltet, zwischen denen jeweils ein winklig zur Kammwand ausgerichteter Saugschlitz gebildet ist, wobei die Auflagefläche jeder Kammwand, die mit einer der Seitenflächen des ihre zugeordneten Wafers in Eingriff kommt, von der Außenfläche der rahmenmäßigen Einfassung der Lamellen und den Stirnkanten der Lamellen gebildet ist, die in der gleichen vertikalen Ebene liegen, in der die Außenfläche der rahmenmäßigen Einfassung liegt, wodurch die Flächenpressung des Wafers pro Flächeneinheit minimiert ist.

Die Erfindung sorgt für eine Erhöhung der Durchsatzkapazität beim Dotierungsprozeß von Wafern in den Diffusionsöfen, ohne deren Größe oder Bauform verändern zu müssen, sowie für eine beträchtliche Verringerung der Gesamtbearbeitungszeit. Weiterhin werden die Transport-, Handhabungs- und Positionierungsvorgänge präzisiert, was eine Reduzierung der Beschädigungs- und/oder Bruchquote und eine Senkung der Fehldotierungsrate der Wafer zur Folge hat Eine Nachrüstung des erfindungsgemäßen Handhabungssystems in herkömmlicher Anlagen zum Be- und Entladen von Prozeßbooten mit Wafern ist ohne weiteres möglich.

Die Erfindung wird nun anhand der Zeichnungen beschrieben. In diesen sind:
**Fig. 1** in Perspektivansicht ein bereitgestellter, mit 2 x 50 Wafern gefüllter Carrier mit einem oberhalb von diesem angeordneten 50-fach Vakuumgreifer eines BTB-Moduls und mit einer seitlich angeordneten Seitenzentrierung,
**Fig. 2** eine der Fig. 1 entsprechende Perspektivansicht, jedoch mit einem ausgehobenen ersten Waferstapel aus 50 Wafern,
**Fig. 3** eine der Fig. 2 entsprechende Perspektivansicht, jedoch mit zwei seitlich angeordneten Seitenzentrierungen,
**Fig. 4** eine der Fig. 3 entsprechende Perspektivansicht, aber mit vom Vakuumgreifer des BTB-Moduls ergriffenen ersten Waferstapel bei freigefahrenem Aushebekamm,
**Fig. 5** eine der Fig. 4 entsprechende Perspektivansicht, jedoch beim Verschwenkens des ersten Waferstapels durch das BTB-Modul,
**Fig. 6** eine der Fig. 5 entsprechende Perspektivansicht, jedoch nach Verschwenken des ersten Waferstapels durch das BTB-Modul um 180° in Bezug auf die Lage des zweiten Waferstapels in dem Carrier und in Bereitstellungs position des ersten Waferstapels über dem im Carrier befindlichen zweiten Waferstapel,
**Fig. 7** eine der Fig. 6 entsprechende Perspektivansicht, jedoch nach Ausheben des zweiten Waferstapels aus dem Carrier und Zusammenfügen mit dem in der ausgehobenen Position bereitstehenden ersten Waferstapel unter Bildung einer paketmäßigen BTB-Wafercharge,
**Fig. 8** eine Perspektivdarstellung eines Transfergreifers bei der Übernahme der paketmäßigen BTB-Wafercharge in der in Fig. 7 ersichtlichen Position,
**Fig. 9** eine Perspektivdarstellung des Transfergreifers über einer Einlegeposition des Prozeßbootes, in der die BTB-Wafercharge nach Überführung durch den Transfergreifer von diesem abgelegt ist, und des entleerten Carriers mit unter diesem angeordneten Aushebekämmen,
**Fig. 10** eine Perspektivdarstellung des BTB-Moduls mit Mehrfach-Vakuumgreifer, der um seine vertikale Achse von einem Servomotor über ein nachgeschaltetes spielfreies Getriebe in Drehung zu versetzen ist,
**Fig. 11** eine schematische Schnittansicht des Mehr-fach-Vakuumgreifers des BTB-Moduls und
**Fig. 12** eine perspektivische Teilschnittansicht eines Sauggreifkamms des Mehrfach-Vakuumgreifers in zwei unterschiedlichen Ausführungsformen.

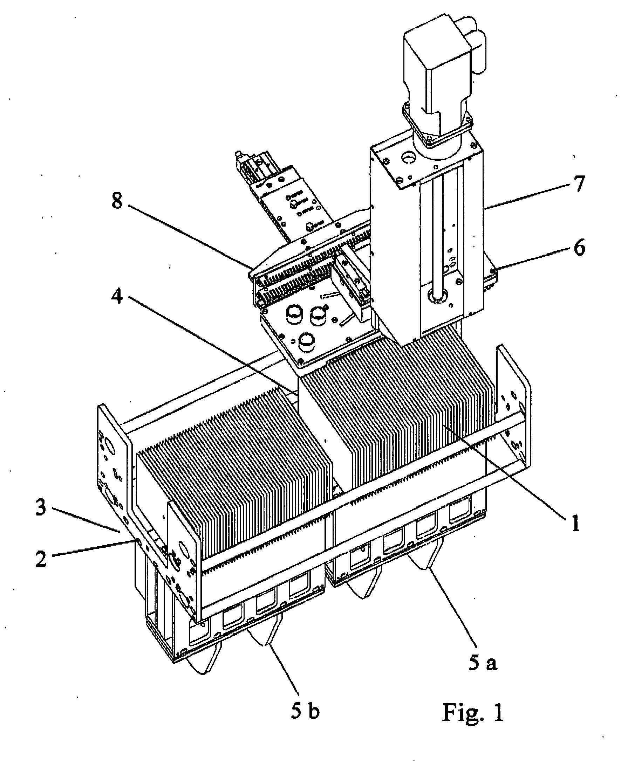

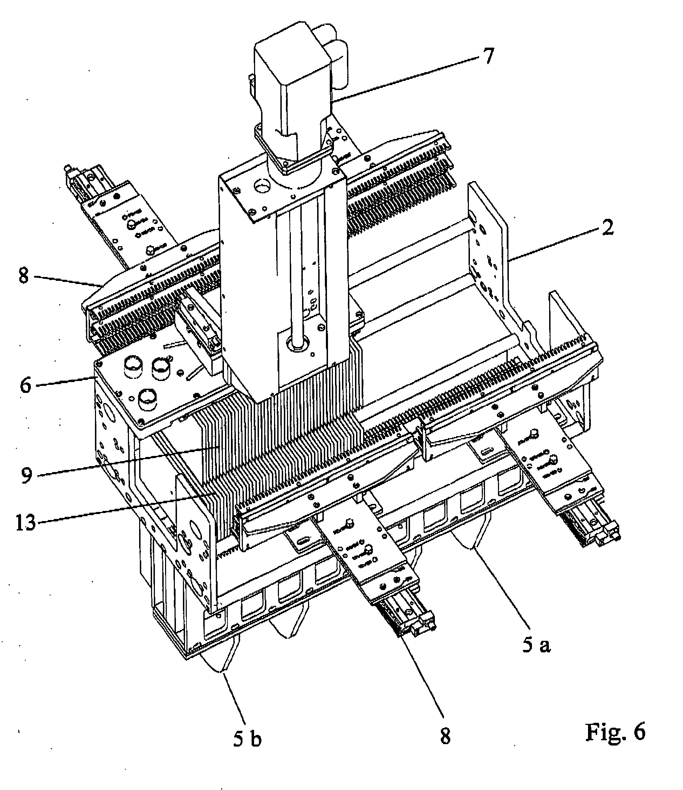

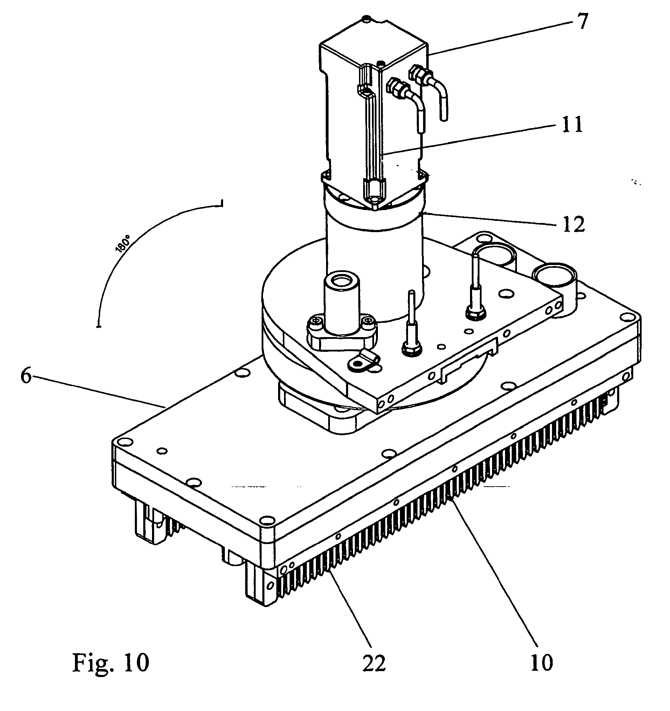

Wie Fig. 1 entnehmbar ist, wird bevorzugt ein mit 2 x 50 Solarwafern 1 gefüllter Carrier 2 in einem Spannmodul 3 derart ausgerichtet und eingespannt, daß seine Einstapelöffnung 4 nach oben weist. Unterhalb des Carriers 2 sind zwei in vertikaler Richtung verfahrbare Aushebekämme 5a und 5b angeordnet, während oberhalb des Carriers 2 ein 50-fach Vakuumgreifer 6 eines Back-To-Back-Moduls (BTB-Moduls) 7 angeordnet ist, wie es gesondert in Fig. 10 dargestellt ist. Zwei linear verfahrbare Zentrierkämme 8 sind ebenfalls oberhalb des Carriers 2 links und rechts (Fig. 6) als Seitenzentrierung positioniert.

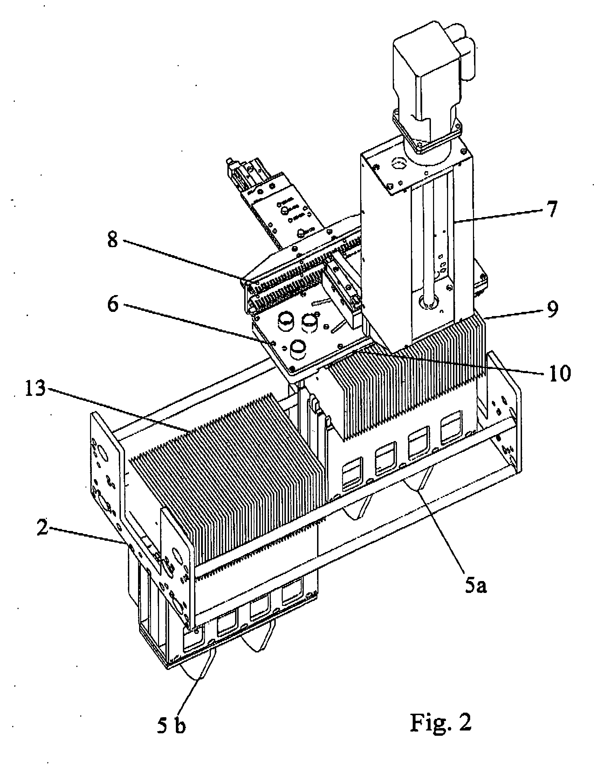

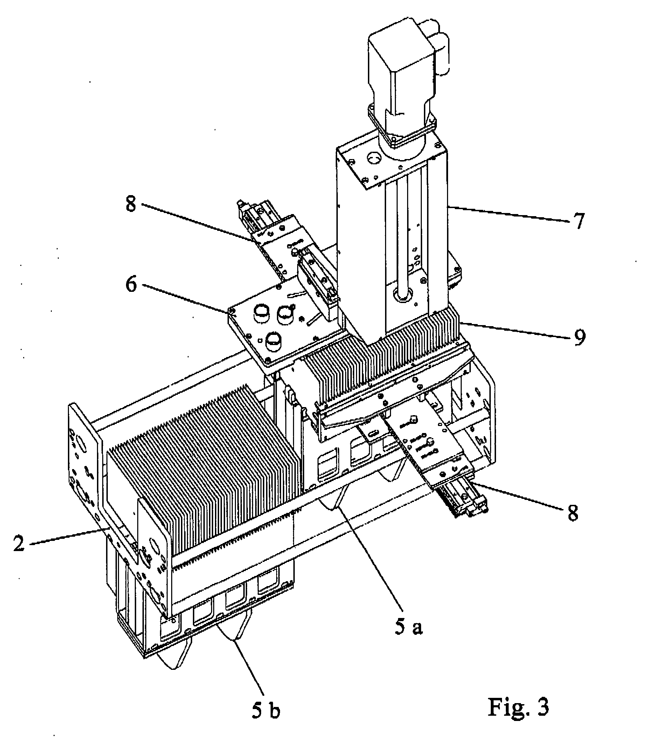

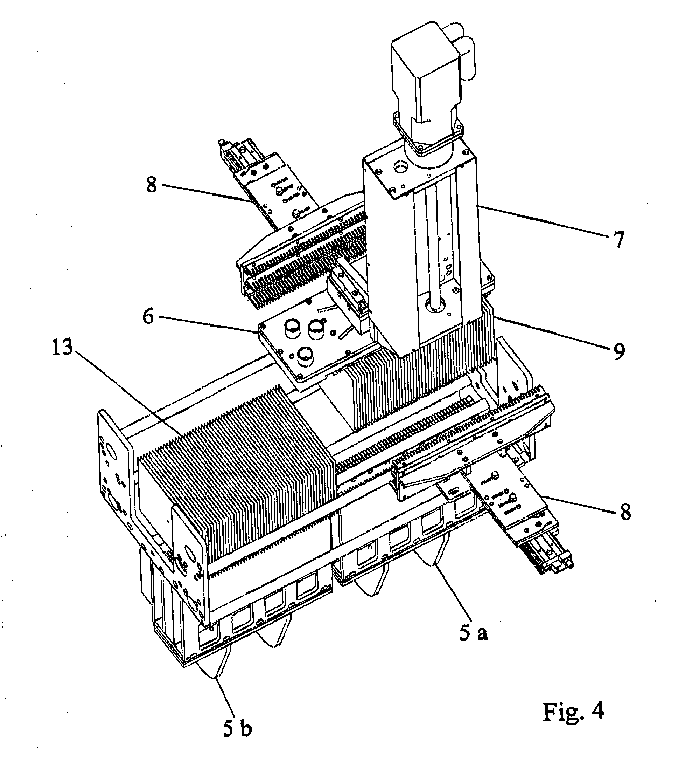

Zunächst werden von dem in Fig. 2 rechten Aushebekamm 5a, dessen Kammlücken exakt zu den Mitten einer ersten Hälfte der Anzahl der im Carrier 2 bereitgestellten Wafer 1 ausgerichtet sind, als erster Waferstapel 9 fünfzig der bereitgestellten Wafer 1 aus dem Carrier 2 in eine erste Aushebeposition überführt, dort von den Zentrierkämmen 8 seitlich zentriert (Fig. 3) und anschließend von zwei 50 Sauggreifkämmen 10 des in X-Y-Z und R-Richtung verfahrbaren Vakuumgreifers 6 des BTB Moduls 7 ergriffen, wie aus Fig. 4 ersichtlich ist.

Wie aus Fig. 10 hervorgeht, ist der Vakuumgreifer 6 mit den Sauggreifkämmen 10 des BTB-Moduls 7 um seine vertikale Achse von einem Servomotor 11 über ein nachgeschaltetes spielfreies Getriebe 12 in Drehung zu versetzen.

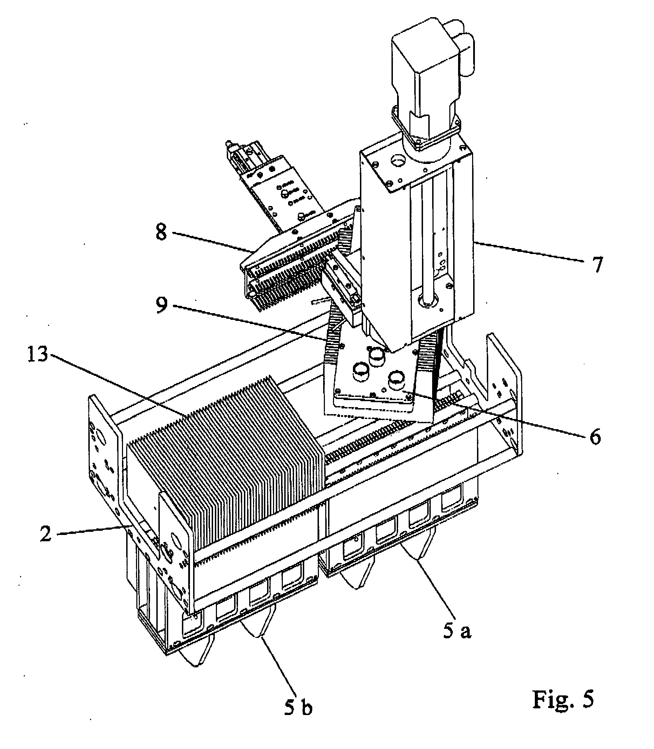

Gemäß Fig. 5 wird daher der von den 50-fach Sauggreifkämmen 10 des Vakuumgreifers 6 ergriffene erste Waferstapel 9 durch Rotation des Vakuumgreifers 6 um 180° um eben diesen Winkel zu seiner Ausgangslage im Carrier 2 verschwenkt und durch Verfahren des Vakuumgreifers 6 in horizontaler Richtung in eine Bereitstellungsposition oberhalb der noch im Carrier 2 verbliebenen zweiten Hälfte der in diesem bereitgestellten 100 Wafer 1 überführt (Fig. 6).

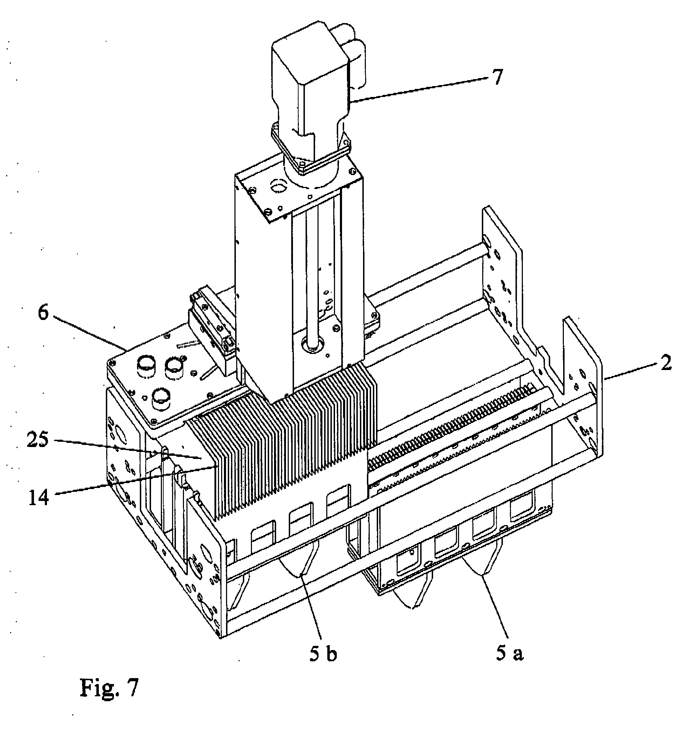

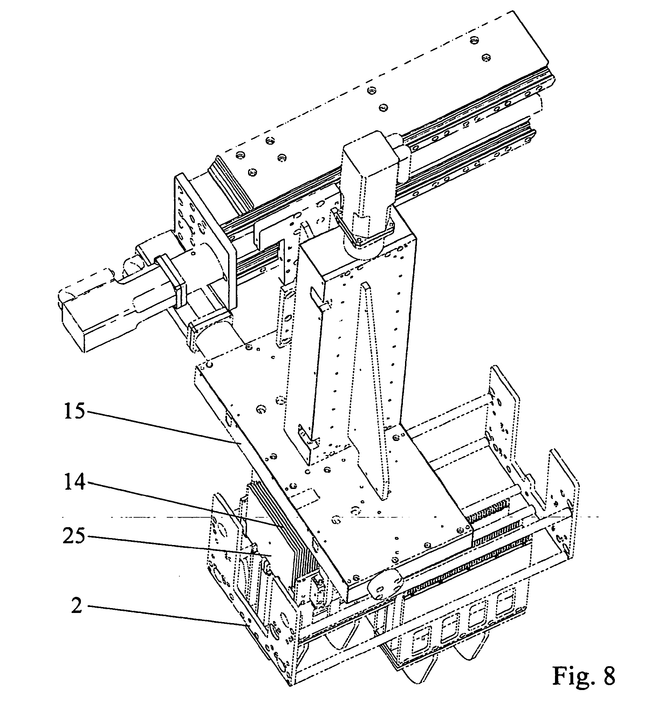

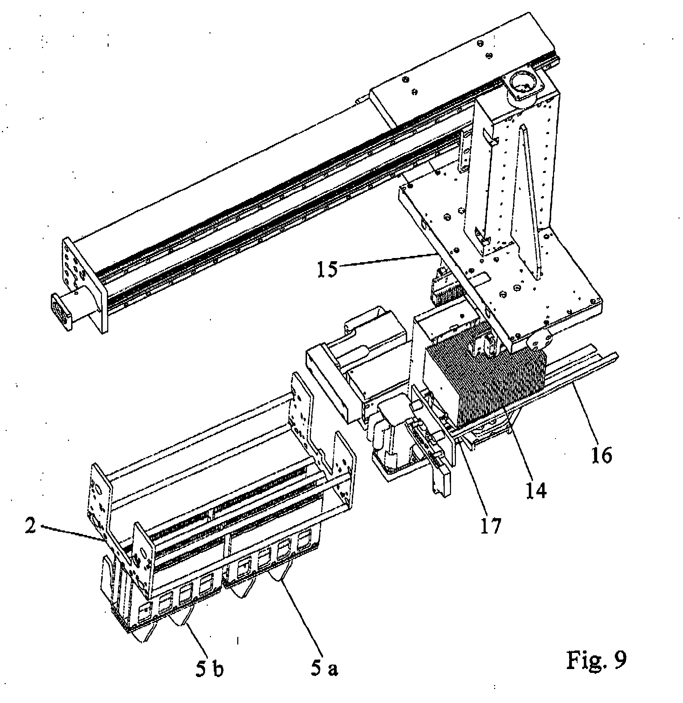

Hierauf wird die im Carrier 2 verbliebene zweite Hälfte der Anzahl der bereitgestellten 100 Wafer 1 von dem zweiten Aushebekamm 5b, dessen Kammlücken exakt zu den Mitten der im Carrier 2 verbliebenen Wafer 1 ausgerichtet sind, als zweiter Waferstapel 13 ausgehoben und zur zweiten Aushebeposition bewegt, die der Bereitstellungsposition des ersten Waferstapels 9 entspricht. Hierbei werden die Wafer 1 des zweiten Waferstapels 13 entlang einer servogesteuerten Bewegungsbahn an den in der Bereitstellungsposition um 180° verschwenkt positionierten zugeordneten Wafern 1 des ersten Waferstapels 9 jeweils bis zur formschlüssigen Deckung vorbeibewegt und dann an diesen unter Bildung einer paketmäßigen Back-To-Back-Wafercharge (BTB-Wafercharge) 14 angelegt, wie aus Fig. 7 ersichtlich ist. Die derart gebildete BTB-Wafercharge 14 wird gemäß Fig. 8 von einem Transfergreifer 15 formschlüssig aus der Bereitstellungsposition entnommen, zu einem Prozeßboot 16 mit vier Einlegepositionen 17 überführt und in einer der Einlegepositionen 17 abgelegt (Fig. 9).

Das Prozeßboot 16 ist somit insgesamt mit 400 Solarwafern (1) für einen Diffusionsvorgang in einem Diffusionsofen zu beladen.

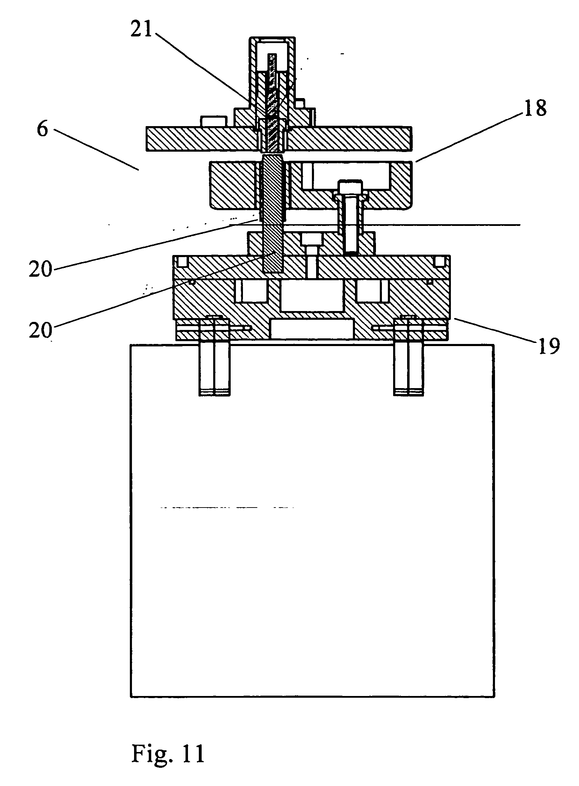

Wie aus der detaillierten Schnittansicht des Vakuumgreifers 6 des BTB-Moduls 7 gemäß Fig. 11 zu ersehen ist, weist der Vakuumgreifer 6 ein mit seiner Vertikalachse verbundenes Oberteil 18 und ein zwei Sauggreifkämme 10 aufnehmendes Unterteil 19 auf, wobei das Oberteil 18 und das Unterteil 19 durch zwei Kugelumlaufführungselemente 20 verbunden und von diesen während einer Bewegung präzise fluchtend gehalten sind. Am Oberteil 18 sind weiterhin zwei induktive Sensoren 21 vorgesehen, von denen beim Absenken des Vakuumgreifers 6 ein Aufsetzen der Unterseite 22 (Fig. 10) der Sauggreifkämme 10 auf die obere Stirnfläche der in den Aushebekämmen 5a; 5b befindlichen Wafer 1 erfaßt wird. Der Einsatz der leichtlaufenden Kugelumlaufführungselemente 20 verbessert die Ansprechzeit wesentlich, sodaß im Aufsetzfall eine geringere Krafteinwirkung auf die Wafer 1 gegeben ist.

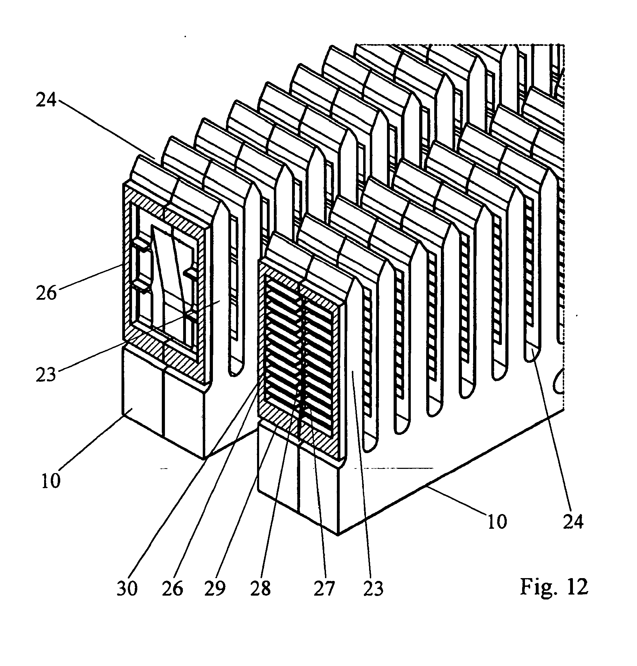

Aus Fig. 12 gehen schließlich zwei mögliche Ausführungsformen der Saugkammgeometrie hervor, bei der die Kammwände 23 der Sauggreifkämme 10 des Mehrfach-Vakuumgreifers 6 des BTB-Moduls 7, die die Aufnahmeschlitze 24 jedes Sauggreifkamms 10 begrenzen und mit den Seitenflächen 25 der Wafer 1 in Eingriff kommen, jeweils eine rahmenmäßige Einfassung 26 aufweisen. Bei der in Fig. 12 vorderen Ausführungsform ist die rahmenmäßige Einfassung 26 vorteilhafterweise mit in dieser zueinander parallelen und horizontal verlaufenden Lamellen 27 gestaltet, zwischen denen jeweils ein winklig zur Kammwand 23 ausgerichteter Saugschlitz 28 gebildet ist. Hierbei ist somit die Auflagefläche jeder Kammwand 23, die mit einer der Seitenflächen 25 des ihr zugeordneten Wafers 1 in Eingriff kommt, von der Außenfläche 29 der rahmenmäßigen Einfassung 26 der Lamellen 27 und den Stirnkanten 30 der Lamellen 27 gebildet, die in der gleichen vertikalen Ebene liegen, in der die Außenfläche 29 der rahmenmäßigen Einfassung 26 liegt. Hierdurch ist die Flächenpressung jedes Wafers 1 pro Flächeneinheit minimiert, was eine beträchtliche Senkung der Beschädigungs- und Bruchquote der Wafer mit sich bringt.

### Liste der Bezugszeichen:

- 1: Wafer, Solarwafer
- 2: Transfercarrier, Carrier
- 3: Spannmodul
- 4: Einstapelöffnung
- 5a, 5b: Aushebekämme
- 6: Vakuumgreifer, Mehrfach-Vakuumgreifer
- 7: Back-To-Back-Modul, BTB-Modul
- 8: Zentrierkämme
- 9: erster Waferstapel
- 10: Sauggreifkamm
- 11: Servomotor
- 12: spielfreies Getriebe
- 13: zweiter Waferstapel
- 14: Back-To-Back-Wafercharge, BTB-Wafercharge
- 15: Tranfergreifer
- 16: Prozeßboot
- 17: Einlegepositionen
- 18: Oberteil des Vakuumgreifers
- 19: Unterteil des Vakuungreifers
- 20: Kugelumlaufführungselemente
- 21: induktive Sensoren
- 22: Unterseite des Saugreifkamms
- 23: Kammwände
- 24: Aufnahmeschlitze des Sauggreifkamms
- 25: Seitenflächen der Wafer
- 26: rahmenmäßige Einfassung
- 27: Lamellen
- 28: Saugschlitz
- 29: Außenfläche der rahmenmäßigen Einfassung
- 30: Stirnkante der Lamellen

## Patentansprüche

1. Verfahren zum Bilden einer in einem Prozeßboot (16) zu positionierenden paketmäßigen Back-To-Back-Wafercharge (BTB-Wafercharge) (14), die aus einer vorbestimmten geraden Anzahl reihenmäßig angeordneter und einseitig zu dotierender Wafer (1) wie Solarwafer besteht, deren nicht zu dotierende Seite jeweils an der nicht zu dotierenden Seite des entsprechenden benachbarten Wafers (1) deckungsgleich angelegt ist, wobei die erste und die zweite Hälfte der vorbestimmten geraden Anzahl Wafer (1) jeweils mittels eines Carriers (2), der mit nach oben weisenden Aufnahmeschlitzen in einer waagerechten Ebene festgespannt wird, in einer Bereitstellungsposition bereitgestellt und nacheinander in Form eines ersten bzw. eines zweiten Waferstapels (9 bzw. 13) aus dem Carrier (2) mittels in vertikaler Richtung verfahrbarer Aushebekämme (5a; 5b), die jeweils unterhalb des Carriers (2) zu positionieren sind, herausbewegt und in einer gemeinsamen Aushebeposition, in der die Wafer (1) des ersten Waferstapels (9) und des zweiten Waferstapels (13) jeweils zueinander um 180° versetzt sind, nacheinander positioniert und zueinander ausgerichtet werden und der zweite Waferstapel (13)
mit dem ersten Waferstapel (9) formschlüssig zu der paketmäßigen Back-To-Back-Wafercharge (BTB-Wafercharge) (14) zusammengefügt wird, indem jeweils die nicht zu dotierenden Seiten der einander zugeordneten Wafer (1) des ersten und des zweiten Waferstapels (9 bzw. 13) gleichzeitig deckungsgleich aneinander gelegt werden, worauf die BTB-Wafercharge (14) von einem Transfergreifer (15) formschlüssig übernommen und an einer Einlegeposition des Prozeßbootes (16) abgelegt wird,
**dadurch gekennzeichnet, dass**
die erste Hälfte und die zweite Hälfte der vorbestimmten geraden Anzahl Wafer (1) für die zu bildende BTB-Wafercharge (14) in den Aufnahmeschlitzen nur eines einzigen Carriers (2) reihenmäßig bereitgestellt werden, aus dem die Wafer (1) in Form des ersten und des zweiten Waferstapels (9 bzw. 13) herausbewegt werden, wobei zunächst der erste Waferstapel (9) in eine weitere Aushebeposition, die ungleich der gemeinsamen Aushebeposition ist, von dem ihm zugeordneten Aushebekamm (5a) gehoben, in dieser von einem in horizontaler Richtung zu verfahrenden Mehrfach-Vakuumgreifer (6) eines BTB-Moduls (7) über induktive Näherungsschalter gesteuert ergriffen, durch Rotation des Mehrfach-Vakuumgreifers (6) um 180° um eben diesen Winkel zu seiner Lage in der Bereitstellungsposition verschwenkt und anschließend durch Verfahren des Mehrfach-Vakuumgreifers (6) in horizontaler Richtung in dieser verschwenkten Lage in der gemeinsamen Aushebeposition positioniert wird, in der nach der Überführung des zweiten Waferstapels (13) mittels des ihm zugeordneten Aushebekamms (5b) in die gemeinsame Aushebeposition die Zusammenfügung des zweiten Waferstapels (13) mit dem ersten Waferstapel (9) erfolgt, indem die Wafer (1) des zweiten Waferstapels (13) jeweils entlang einer servogesteuerten Bewegungsbahn an den in der gemeinsamen Aushebeposition positionierten Wafern (1) des ersten Waferstapels (9) bis zur formschlüssigen Deckung vorbeibewegt und dann die Wafer (1) des ersten Waferstapels (9) zusammen mit den Wafern (1) des zweiten Waferstapels (13) Rücken an Rücken in dem dem zweiten Waferstapel (13) zugeordneten Aushebekamm (5b) angelegt werden.

2. Verfahren zum Bilden einer in einem Prozeßboot (16) zu positionierenden paketmäßigen Back-To-Back-Wafercharge (BTB-Wafercharge) (14), die aus einer vorbestimmten geraden Anzahl reihenmäßig angeordneter und einseitig zu dotierender Wafer (1) wie Solarwafer besteht, deren nicht zu dotierende Seite jeweils an der nicht zu dotierenden Seite des entsprechenden benachbarten Wafers (1) deckungsgleich anliegt, wobei die vorbestimmte Anzahl der einseitig zu dotierenden Wafer (1) in den Aufnahmeschlitzen eines Carriers (2) reihenmäßig bereitgestellt wird, der in einer waagerechten Ebene mit nach oben weisenden Aufnahmeschlitzen festgespannt wird , eine Hälfte der vorbestimmten geraden Anzahl Wafer (1) für die zu bildende BTB-Wafercharge (14) aus dem Carrier (2) bewegt und in Form eines ersten Waferstapels (9) mittels einer Transfereinrichtung (15) zu dem Prozeßboot (16) überführt und in dessen Aufnahmeschlitzen in einer Einlegeposition positioniert wird, dann die andere Hälfte der vorbestimmten Anzahl Wafer (1) für die zu bildenden BTB-Wafercharge (14) aus dem Carrier (2) bewegt und in Form eines zweiten Waferstapels (13), dessen Wafer (1) zuvor um 180° in Bezug auf die Lage der Wafer (1) des ersten Waferstapels (9) in der Einlegeposition des Prozeßbootes (16) versetzt worden sind, von der Transfereinrichtung (15) zu dem Prozeßboot (16) überführt, oberhalb in Ausrichtung zu den in der Einlegeposition des ersten Waferstapels (9) im Prozeßboot (16) befindlichen Wafern (1) um einen Abstand zu der Einlegeposition versetzt positioniert wird, der mindestens so groß wie die Waferdicke ist, und dann mit dem in der Einlegeposition des Prozeßbootes (16) positionierten ersten Waferstapel (9) zusammengefügt wird, indem jeweils die nicht zu dotierenden Seiten der einander zugeordneten Wafer (1) des ersten und des zweiten Waferstapels (9 bzw. 13) gleichzeitig deckungsgleich aneinandergelegt werden,
**dadurch gekennzeichnet, dass**
als Transfereinrichtung ein Mehrfach-Vakuumgreifer (15) eines BTB-Moduls (7) verwendet wird, von dem die erste und die zweite Hälfte der vorbestimmten geraden Anzahl Wafer (1) für die zu bildende BTB-Wafercharge (14), nacheinander in Form des ersten bzw. des zweiten Waferstapels unmittelbar aus dem Carrier (2) entnommen und nacheinander servogesteuert zu der Einlegeposition des Prozeßbootes (16) überführt werden, wobei der vom Mehrfach-Vakuumgreifer (15) aus dem Carrier (2) entnommene zweite Waferstapel (13) durch Rotation des Mehrfach-Vakuumgreifers (15) bei der Überführung zum Prozeßboot (16) in die um 180° versetzte Lage in Bezug auf die Lage des bereits in der Einlageposition des Prozeßbootes (16) positionierten ersten Waferstapels (9) verschwenkt wird.

3. Handhabungssystem zum Beschicken eines mehrere Einlegepositionen (17) aufweisenden Prozeßbootes (16) mit Waferchargen (14) vor der Dotierung in einem Diffusionsofen, mit einer automatischen Transferanlage, von der ein mit einer vorbestimmten geraden Anzahl Wafer (1) bestückter Carrier (2) in einer waagerechten Transportebene in eine Bereitstellungsposition zur Bildung von Waferstapeln (9; 13) zu bewegen ist, mit einem Spannmodul (3), von dem der Carrier (2) mit nach oben weisenden Aufnahmeschlitzen in der Bereitstellungsposition derart ausgerichtet festzuhalten ist, dass die Mitten der in den Aufnahmeschlitzen des Carriers (2) befindlichen Wafer (1) exakt zu den Kammlücken von in vertikaler Richtung verfahrbaren Aushebekämmen (5a; 5b) eines ersten und eines zweiten Vertikal-Achsmoduls ausgerichtet sind, die jeweils fest unterhalb des Spannmoduls (3) in der Bereitstellungsposition angeordnet sind, wobei von dem Aushebekamm (5a) des ersten Vertikal-Achsmoduls die erste Hälfte der vorbestimmten Anzahl der Wafer (1) in dem vom Spannmodul (3) gehaltenen Carrier (2) als erster Waferstapel (g) nach oben in eine erste Aushebeposition zu bewegen und in dieser mittels einer Dreheinrichtung in einer um 180° versetzte Lage in Bezug auf seiner Lage in der Bereitstellungsposition in dem Aushebekamm (5a) des ersten Vertikal-Achsmoduls vorzusehen und der Aushebekamm (5a) wieder runterzufahren ist, anschließend von dem Aushebekamm (5b) des zweiten Vertikal-Achsmoduls die zweite Hälfte der Anzahl der in den Aufnahmeschlitzen des Carriers (2) befindlichen Wafer (1) als zweiter Waferstapel (13) in eine zweite Aushebeposition auszuheben ist, dann der zweite Waferstapel (13) ohne Drehung in die erste Aushebeposition oberhalb des ersten Waferstapels (9) zu bewegen ist, in die der erste Waferstapel (9) von dem Aushebekamm (5a) des ersten Vertikal-Achsmoduls hochzufahren und in den zweiten Waferstapel (13) einzufügen ist und die Wafer (1) des ersten und des zweiten Waferstapels (9 bzw. 13) Rücken an Rücken unter Bildung einer paketmäßigen BTB-Wafercharge (14) mit verdoppelter Dotierungsfläche im Aushebekamm (5a) des ersten Vertilkal-Achsmoduls anzulegen sind, und mit einem Transfergreifer (15), von dem die gebildete BTB-Wafercharge (14) von der ersten Aushebeposition zum Prozeßboot (16) zu bewegen und an einer der Einlegepositionen abzulegen ist,
**gekennzeichnet durch**
ein Back-To-Back-Modul (BTB-Modul) (7), das einen oberhalb des Spannmoduls (3) angeordneten und in eine X-Y-Z und R-Richtung verfahrbaren Mehrfach-Vakuumgreifer (6) mit Sauggreiflcämmen (10) aufweist, der um seine vertikal gerichtete Achse von einem Servomotor (11) über ein nachgeschaltetes spielfreies Getriebe (12) in Drehung zu versetzen ist, und ein Zentriermodul von dem die Anzahl Wafer (1) des aus dem Carrier (2) in die erste bzw. zweite Aushebeposition gehobenen ersten bzw. zweiten Waferstapels (9 bzw. 13) an den seitlichen Kanten und mit exaktem Abstand der Wafer (1) zu einander in dem ersten bzw. zweiten Waferstapel (9 bzw. 13) auszurichten ist, wobei der erste Waferstapel (9) in der ersten Aushebeposition von dem Mehrfach-Vakuumgreifer (6) des Back-To-Back-Moduls (BTB-Modul) (7) über induktive Näherungsschalter gesteuert zu ergreifen, um den Winkel von 180° zu verschwenken und ohne Relativbewegung in Bezug auf den Aushebekamm (5a) des ersten Vertikal-Achsmoduls in diesem in der um 180° verschwenkten Lage in der ersten Aushebeposition wieder abzulegen und der Aushebekamm (5a) des ersten Vertikal-Achsmoduls wieder runterzufahren ist, anschließend der in die zweite Aushebeposition ausgehobene zweite Waferstapel (13) von dem Mehrfach-Vakuumgreifer (6) des Back-To-Back-Moduls (BTB-Modul) (7) zu ergreifen und ohne Drehung in die erste Aushebeposition oberhalb des ersten Waferstapels (9) zu bewegen ist, in der die Wafer (1) des von dem Aushebekamm (5a) des ersten Vertikal- Achsmoduls hochzufahrenden ersten Waferstapels (9) entlang einer servogesteuerten Bewegungsbahn an den zugeordneten Wafern (1) des zweiten Waferstapels (13) vorbeizubewegen und die Wafer (1) des zweiten Waferstapels (13) zusammen mit den Wafern (1) des ersten Waferstapels (9) Rücken an Rücken in dem hochgefahrenen Aushebekamm (5a) des ersten Vertikal-Achsmoduls anzulegen sind.

4. Handhabungssystem nach Anspruch 3, **dadurch gekennzeichnet, dass** der Mehrfach-Vakuumgreifer (6) des BTB-Moduls (7) ein mit dessen Vertikalachse verbundenes Oberteil (18) und ein Sauggreifkämme (10) aufnehmendes Unterteil (19) aufweist, daß das Oberteil (18) und das Unterteil (19) durch zwei Kugelumlaufführungselemente (20) verbunden und von diesen während einer Bewegung präzise fluchtend gehalten sind, und dass am Oberteil (18) des Mehrfach-Vakuumgreifers (6) zwei induktive Sensoren (21) vorgesehen sind, von denen beim Absenken des Mehrfach-Vakuumgreifers (6) ein Aufsetzen der Unterseite (22) der Sauggreifkämme (10) auf die oberen Stirnflächen der im Carrier (2) befindlichen Wafer (1) zu erfassen und ein weiteres Absenken des Mehrfach-Vakuumgreifers (6) mit minimaler Verzögerung zu sperren ist.

5. Handhabungssystem nach einem der Ansprüche 3 und 4, **dadurch gekennzeichnet, dass** der Mehrfach-Vakuumgreifer (6) zwei Sauggreifkämme (10) mit jeweils 50 Kammwände (23) aufweist, mit denen insgesamt 50 Solarwafer (1) zu ergreifen sind.

6. Handhabungssystem nach Anspruch 5 **dadurch gekennzeichnet, dass** die Kammwände (23) der Sauggreifkämme (10) des Mehrfach-Vakuumgreifers (6), die die Aufnahmeschlitze (24) jedes Sauggreifkamms (10) begrenzen und mit den Seitenflächen (25) der Wafer (1) in Eingriff kommen, jeweils in Form einer rahmenmäßigen Einfassung (26) mit zueinander parallelen und horizontal verlaufenden Lamellen (27) gestaltet ist, zwischen denen jeweils ein winklig zur Kammwand (23) ausgerichteter Saugschlitz (28) gebildet ist, und dass die Auflagefläche jeder Kammwand (23), die mit einer der Seitenflächen (25) des ihre zugeordneten Wafers (1) in Eingriff kommt, von der Außenfläche (29) der rahmenmäßigen Einfassung (26) der Lamellen (27) und den Stirnkanten (30) der Lamellen (27) gebildet ist, die in der gleichen vertikalen Ebene liegen, in der die Außenfläche (29) der rahmenmäßigen Einfassung (26) liegt, wobei die Flächenpressung des Wafers (1) pro Flächeneinheit minimiert ist.

## Claims

1. A method of forming a package-like back-to-back wafer batch (BTB wafer batch) (14) to be positioned in a process boat (16), the back-to-back wafer batch consisting of a predetermined even number of wafers (1) disposed in rows, such as solar wafers, to be doped on one side, with each side that is not to be doped abutting congruently the side not to be doped of the respective adjacent wafer (1), wherein the first and the second half of the predetermined even number of wafers (1) is provided in a standby position in each case by means of a carrier (2), which is clamped in a horizontal plane with upward facing stacking slots, and moved out of the carrier (2) in succession in the form of a first and a second wafer stack, respectively (9 and 13, respectively) by means of lifting combs (5a; 5b) that can travel vertically and are each positioned beneath the carrier (2), and positioned in succession in a combined lifting position, in which the wafers (1) of the first wafer stack (9) and the second wafer stack (13) are each offset by 180° with respect to one another and aligned to one another and the second wafer stack (13) is joined together with the first wafer stack (9) by positive locking to produce the package-like back-to-back wafer batch (BTB wafer batch) (14), by simultaneously and congruently joining together the sides not to be doped of the wafers (1) of the first and the second wafer stack (9 and 13, respectively) associated to one another, whereupon the BTB wafer batch (14) is picked up in positively locked form by a transfer gripper (15) and deposited at an insertion position in the process boat (16),
**characterised in that**
the first half and the second half of the predetermined even number of wafers (1) for the BTB wafer batch (14) to be formed are provided in rows in the stacking slots of only a single carrier (2), from which the wafers (1) are moved out in the form of the first and the second wafer stack (9 and 13, respectively), wherein the first wafer stack (9) is first lifted by its associated lifting comb (5a) into a lifting position other than the combined lifting position, picked up from there by a multi-vacuum gripper (6) of a BTB module (7) to be moved in a horizontal direction, controlled by inductive proximity switches, the multi-vacuum gripper (6) is swivelled by rotation through 180° relative to this angle to its place in the standby position and is then positioned by moving the multi-vacuum gripper (6) horizontally in this swivelled position in the combined lifting position, in which following transfer of the second wafer stack (13) by means of its associated lifting comb (5b) into the combined lifting position, the second wafer stack (13) and the first wafer stack (9) are joined together, with the wafers (1) of the second wafer stack (13) each being moved along a servo-controlled movement path past the wafers (1) of the first wafer stack (9) positioned in the combined lifting position to the positively-locked cover and then the wafers (1) of the first wafer stack (9) along with the wafers (1) of the second wafer stack (13) being placed back-to-back in the lifting comb (5b) associated with the second wafer stack (13).

2. A method for forming a package-like back-to-back wafer batch (BTB wafer batch) (14) to be positioned in a process boat (16), the back-to-back wafer batch consisting of a predetermined even number of wafers (1) disposed in rows, such as solar wafers, to be doped on one side, with each side which is not to be doped abutting congruently the side not to be doped of the respective adjacent wafer (1), wherein the predetermined number of wafers (1) to be doped on one side is provided in rows in the stacking slots of a carrier (2), which is clamped in a horizontal plane with upward facing stacking slots, half of the predetermined even number of wafers (1) for the BTB wafer batch (14) to be formed is moved from the carrier (2) and transferred in the form of a first wafer stack (9) by means of a transfer mechanism (15) to the process boat (16) and positioned in an insertion position in its stacking slots, then the other half of the predetermined number of wafers (1) for the BTB wafer batch (14) to be formed is moved from the carrier (2) and transferred by the transfer mechanism (15) to the process boat (16) in the form of a second wafer stack (13), the wafers (1) of which have previously been offset by 180° with respect to the position of the wafers (1) of the first wafer stack (9) in the insertion position of the process boat (16), positioned above wafers (1) in alignment with the insertion position of the first wafer stack (9) in the process boat (16), offset from the insertion position by a distance at least as great as the wafer thickness, and then joined together with the first wafer stack (9) in the insertion position of the process boat (16), with the sides not to be doped of the wafers (1) of the first and the second wafer stack (9 and 13, respectively) associated with each other being placed together simultaneously and congruently,
**characterised in that**
a multi-vacuum gripper (15) of a BTB module (7) is used as the transfer mechanism, by which the first and the second half of the aforementioned even number of wafers (1) for the BTB wafer batch (14) to be formed is removed straight from the carrier (2) in succession in the form of the first and second wafer stacks, respectively, and transferred in succession by servo control to the insertion position of the process boat (16), wherein the second wafer stack (13) taken from the carrier (2) by the multi-vacuum gripper (15) is swivelled by rotation of the same during transfer to the process boat (16) into the position which is offset by 180° with respect to the position of the first wafer stack (9) already in the insertion position of the process boat (16).

3. A handling system for loading a process boat (16) with several insertion positions (17) with wafer batches (14) before doping in a diffusion furnace, with an automatic transfer system by which a carrier (2) fitted with a predetermined even number of wafers (1) can be moved along a horizontal transport plane into a standby position for forming wafer stacks (9; 13), with a clamping module (3), from which the carrier (2) must be held aligned with upward facing stacking slots in the standby position, so that the centres of the wafers (1) in the stacking slots of the carrier (2) are precisely aligned with the comb holes of lifting combs (5a; 5b) that can be moved vertically of a first and a second vertical axis module, which are each rigidly disposed beneath the clamping module (3) in the standby position, wherein the first half of the predetermined number of wafers (1) in the carrier (2) held by the clamping module (3) is moved by the lifting comb (5a) of the first vertical axis module as the first wafer stack (9) upwards into a first lifting position and is to be provided here by means of a rotating mechanism in a position offset by 180° with respect to its standby position in the lifting comb (5a) of the first vertical axis module and the lifting comb (5a) is lowered again, after which the second half of the number of wafers (1) located in the stacking slots of the carrier (2) is lifted into a second lifting position by the lifting comb (5b) of the second vertical axis module, then the second wafer stack (13) is moved without rotation into the first lifting position above the first wafer stack (9), into which the first wafer stack (9) is raised by the lifting comb (5a) of the first vertical axis module and inserted in the second wafer stack (13) and the wafers (1) of the first and the second wafer stack (9 and 13, respectively) are placed together back-to-back forming a packet-like BTB wafer batch (14) with a doubled doping surface in the lifting comb (5a)of the first vertical axis module, and with a transfer gripper (15), by which the formed BTB wafer batch (14) is moved from the first lifting position to the process boat (16) and deposited at one of the insertion positions,
**characterised in that**
a back-to-back module (BTB module) (7) with a multi-vacuum gripper (6) with vacuum gripping combs (10), being disposed above the clamping module (3) and movable in an X-Y-Z and R direction, the vertically oriented axis of which is rotated by a servo motor (11) via a downstream play-free gear (12) and a centring module, by which the number of wafers (1) of the first and second wafer stacks, respectively (9 and 13, respectively) lifted out of the carrier (2) into the first or second lifting position must be aligned at the side edges with the wafers (1) being at an exact distance from one another in the first and second wafer stack, respectively (9 and 13, respectively), wherein the first wafer stack (9) is picked up from the first lifting position by the multi-vacuum gripper (6) of the back-to-back module (BTB module) (7) controlled by inductive proximity switches, swivelled through 180° and without any relative movement in relation to the lifting comb (5a) of the first vertical axis module deposited again in this in the position offset at 180° in the first lifting position and the lifting comb (5a) of the first vertical axis module is lowered again, after which the second wafer stack (13) moved into the second lifting position is picked up by the multi-vacuum gripper (6) of the back-to-back module (BTB module) (7) and moved without rotation into the first lifting position above the first wafer stack (9), in which the wafers (1) of the first wafer stack (9) raised by the lifting comb (5a) of the first vertical axis module are moved along a servo-controlled movement path past the wafers (1) associated with the second wafer stack (13) and the wafers (1) of the second wafer stack (13) along with the wafers (1) of the first wafer stack (9) are placed back-to-back in the raised lifting comb (5a) of the first vertical axis module.

4. Handling system according to claim 3, **characterized in that** the multi-vacuum-gripper (6) of the BTB-module (7) comprises an upper part (18) connected to the vertical axis thereof and a bottom part (19) supporting vacuum gripping combs (10), that the upper part (18) and the bottom part (19) are connected via two ball screw guide elements (20) and are kept by them precisely aligned during a movement and that two inductive sensors (21) are provided at the upper part (18) of the multi-vacuum-gripper (6) by which upon lowering of the multi-vacuum-gripper (6) an abutting of the bottom side (22) of the vacuum gripping combs (10) upon the upper front faces of the wafers (1) located in the carrier (2) is to be detected and a further lowering of the multi-vacuum-gripper (6) is to be blocked with minimal delay.

5. Handling system according to any one of claim 3 and claim 4, **characterized in that** the multi-vacuum-gripper (6) comprises 2 vacuum-gripping combs (10) each with 50 combwalls (23) by which total 50 solarwafers (1) are to be gripped.

6. Handling system according to claim 5, **characterized in that** the comb walls (23) of the vacuum gripping combs (10) of the multi-vacuum-gripper (6), which define the reception slots (24) of each vacuum gripping comb (10) and engage with the side surfaces (25) of the wafers (1), are each shaped in the form of a frame-like bezel (26) having fins (27) parallel and horizontal extending to each other, with respectively one vacuum slot (28) formed therebetween oriented at an angle to the comb wall (23), and that the supporting surface of each comb wall (23) engaging with one of the side surfaces (25) of its associated wafer (1) is formed by the outer surface (29) of the frame-like bezel (26) of the fins (27) and the front edges (30) of the fins (27) which lie in the same vertical plane, in which the outer surface (29) of the frame-like bezel (26) lies, whereby the contact pressure per unit area of the wafer (1) is minimized.

## Revendications

1. Procédé pour former des groupes de tranches de silicium dos à dos (groupe de tranches de silicium BTB) (14) en paquets et à charger dans une nacelle (16), qui comprend un nombre pair prédéfini de tranches de silicium (1) disposées en rangées et à doper sur un côté telles que des tranches de silicium solaires, dont le côté qui n'est pas à doper s'applique par recouvrement respectivement sur le côté qui n'est pas à doper de la tranche de silicium (1) voisine correspondante, la première et la seconde moitiés du nombre pair prédéfini de tranches (1) étant mises à disposition respectivement au moyen d'un support (2), qui est fixé avec des fentes de logement dirigées vers le haut dans un plan horizontal, dans une position d'attente et étant déplacées de façon successive sous la forme d'une première ou d'une seconde pile de tranches (9 et 13) à la sortie du support (2) au moyen de peignes de soulèvement (5a ; 5b) déplaçables dans le sens vertical, qui doivent être positionnées respectivement au-dessous du support (2), et étant positionnées les unes après les autres et orientées les unes par rapport aux autres dans une position de soulèvement commune, dans laquelle les tranches (1) de la première pile de tranches (9) et de la seconde pile de tranches (13) sont décalées à chaque fois de 180° les unes par rapport aux autres, et la seconde pile de tranches (13) étant assemblée avec la première pile de tranches (9) par complémentarité de formes pour former les groupes de tranches de silicium dos à dos en paquets (groupe de tranches de silicium BTB) (14), par le fait qu' à chaque fois les côtés, qui ne sont pas à doper des tranches de silicium (1) attribuées les unes aux autres de la première et de la seconde piles de tranches (9 et 13) sont appliquées les unes contre les autres simultanément par recouvrement, après quoi le groupe de tranches de silicium BTB (14) est pris en charge par complémentarité de formes dans une pince de transfert (15) et est déposé sur une position d'insertion de la nacelle (16),
**caractérisé en ce que**
la première et la seconde moitiés du nombre pair prédéfini des tranches de silicium (1) sont mises à disposition par rangées pour le groupe de tranches de silicium BTB (14) à former dans les fentes de logement de uniquement un seul support (2), à partir duquel les tranches de silicium (1) sont déplacées sous la forme de la première et de la seconde piles de tranches (9 et 13), la première pile de tranches (9) étant soulevée d'abord dans une première position de soulèvement, qui est différente de la position de soulèvement commune, du peigne de soulèvement (5a) qui lui est attribué, étant saisie dans cette position par une pince à vide multiple (6), à déplacer dans le sens horizontal, d'un module BTB (7), commandé par des détecteurs de proximité inductifs, étant basculée par rotation de la pince à vide multiple (6) de 180° autour de précisément cet angle par rapport à sa position dans la position d'attente et état positionnée ensuite par le déplacement de la pince à vide multiple (6) dans la direction horizontale dans cette position basculée dans la position de soulèvement commune, dans laquelle, après le transfert de la seconde pile de tranches de silicium (13) au moyen du peigne de soulèvement (5b) qui lui est attribué dans la position de soulèvement commune, l'assemblage de la seconde pile de tranches (13) s'effectue avec la première pile de tranches (9) par le fait que les tranches (1) de la seconde pile (13) sont déplacées à chaque fois le long d'une trajectoire de déplacement contrôlée par servocommande en passant devant les tranches (1), positionnées dans la position de soulèvement commune, de la première pile de tranches (9), jusqu'au recouvrement par complémentarité de formes et ensuite les tranches (1) de la seconde pile de tranches (9) sont appliquées conjointement avec les tranches (1) de la seconde pile de tranches (13) dos à dos dans le peigne de soulèvement (5b) attribué à la seconde pile de tranches (13).

2. Procédé pour former des groupes de tranches de silicium dos à dos (tranches de silicium BTB) (14) en paquets, à charger dans une nacelle (16), qui comprend d'un nombre pair prédéfini de tranches de silicium (1) disposées en rangées et à doper sur un côté telles que des tranches solaires, dont le côté qui n'est pas à doper s'applique par recouvrement respectivement sur le côté qui n'est pas à doper de la tranche (1) voisine correspondante, le nombre prédéfini des tranches (1) à doper sur un côté étant mis à disposition par rangées dans les fentes de logement d'un support (2), lequel est fixé dans un plan horizontal avec des fentes de logement dirigées vers le haut, une moitié du nombre pair prédéfini de tranches (1) étant déplacée à partir du support (2) pour les groupes de tranches de silicium BTB (14) à former et étant transmise sous la forme d'une première pile de tranches (9) au moyen d'un dispositif de transfert (15) à la nacelle (16) et étant positionnée dans ses fentes de logement dans une position d'insertion, l'autre moitié du nombre prédéfini de tranches (1) pour les groupes de tranches de silicium BTB (14) à former étant déplacées ensuite à partir du support (2) et étant transférée sous la forme d'une seconde pile de tranches (13), dont les tranches (1) ont été décalées auparavant de 180° par rapport à la position des tranches (1) de la première pile de tranches (9) dans la position d'insertion de la nacelle (16), du dispositif de transfert (15) à la nacelle (16), étant positionnée au-dessus en alignement avec les tranches (1) se trouvant dans la position d'insertion de la première pile de tranches (9) dans la nacelle (16), décalée d'une distance par rapport à la position d'insertion, laquelle distance est au moins aussi grande que l'épaisseur de tranche, et étant assemblée ensuite avec la première pile de tranches (9) positionnée dans la position d'insertion de la nacelle (16), du fait qu'à chaque fois les côtés, qui ne sont pas à doper, des tranches (1) attribuées les unes aux autres de la première et de la seconde piles de tranches (9 et 13) sont appliquées les unes contre les autres simultanément par recouvrement,
**caractérisé en ce que**
une pince à vide multiple (15) d'un module BTB (7) est utilisée comme dispositif de transfert, pince par laquelle la première et la seconde moitiés du nombre pair prédéfini de tranches (1) sont prélevées directement du support (2) pour les groupes de tranches de silicium BTB (14) à former, de façon successive sous la forme de la première et de la seconde piles de tranches, et sont transférées de façon successive et contrôlées par servocommande dans la position d'insertion de la nacelle (16), la seconde piles de tranches (13) prélevée par la pince à vide multiple (15) du support (2) étant basculée par rotation de la pince à vide multiple (1) lors du transfert à la nacelle (16) dans la position décalée de 180° par rapport à la position de la première pile de tranches (9) positionnée déjà dans la position d'insertion de la nacelle (16).

3. Système de manipulation pour l'alimentation d'une nacelle (16) présentant plusieurs positions d'insertion avec des groupes de tranches de silicium (14) avant le dopage dans un four à diffusion, avec une installation de transfert automatique par laquelle un support (2) équipé d'un nombre pair prédéfini de tranches (1) doit être déplacé dans un plan de transport horizontal dans une position d'attente pour la formation de piles de tranches (9 ; 13), avec un module de serrage (3), par lequel le support (2) doit être maintenu avec des fentes de logement dirigées vers le haut dans la position d'attente, orienté de telle sorte que les centres des tranches de silicium (1) se trouvant dans les fentes de logement du support (2) sont orientés de façon précise par rapport aux vides de peignes de soulèvement (5a ; 5b), déplaçables dans la direction verticale, d'un premier module d'axe vertical et d'un second module d'axe vertical, lesquels sont disposés respectivement de façon fixe au-dessous du module de serrage (3) dans la position d'attente, la première moitié du nombre prédéfini des tranches (1) devant être déplacée par le peigne de soulèvement (5a) du premier module d'axe vertical dans le support (2) maintenu par le module de serrage (3) comme première pile de tranches (9) vers le haut dans une première position de soulèvement et devant être prévue dans cette position au moyen d'un dispositif de rotation dans une position décalée de 180° par rapport à sa position dans la position d'attente dans le peigne de soulèvement (5a) du premier module d'axe vertical et le peigne de soulèvement (5a) devant être à nouveau descendu, la seconde moitié du nombre de tranches de silicium (1) se trouvant dans les fentes de logement du support (2) devant être soulevée ensuite en tant que seconde pile de tranches (13) du peigne de soulèvement (5b) du second module d'axe vertical dans une seconde position de soulèvement, la seconde pile de tranches (13) devant être déplacée ensuite sans rotation dans la première position de soulèvement au-dessus de la première pile de tranches (9), position dans laquelle la première pile de tranches (9) doit être soulevée par le peigne de soulèvement (5a) du premier module d'axe vertical et doit être insérée dans la seconde pile de tranches de silicium (13) et les tranches (1) de la première et de la seconde piles (9 et 13) doivent être appliquées dos à dos en formant un groupe de tranches de silicium BTB (14) en paquets avec une surface de dopage doublée dans le peigne de soulèvement (5a) du premier module d'axe vertical, et avec une pince de transfert (15), par laquelle le groupe de tranches de silicium BTB (14) formé doit être déplacé de la première position de soulèvement vers la nacelle (16) et doit être déposée sur l'une des positions d'insertion,
**caractérisé par**
un module dos à dos (module BTB) (7), qui présente une pince à vide multiple (6) disposée au-dessus du module de serrage (3) et déplaçable dans une direction X-Y-Z et une direction R avec des peignes à pince aspirants (10), qui doit être mis en rotation autour de son axe orienté verticalement par un servomoteur (11) au moyen d'un engrenage (12) sans jeu placé en aval, et un module de centrage (8), par lequel le nombre de tranches (1) de la première et de la seconde piles de tranches (9 et 13) soulevées du support (2) dans la première ou la seconde position de soulèvement peut être orienté sur les arêtes latérales et à une distance exacte des tranches (1) les unes par rapport aux autres dans la première ou la seconde pile de tranches (9 et 13), la première pile de tranches (9) devant être saisie dans la première position de soulèvement par la pince à vide multiple (6) du module dos à dos (module BTB) (7) de façon commandée par des capteurs de proximité inductifs, afin de basculer l'angle de 180° et de la déposer à nouveau sans déplacement relatif par rapport au peigne de soulèvement (5a) du premier module d'axe vertical dans ce peigne dans la position basculée de 180° dans la première position de soulèvement et le peigne de soulèvement (5a) du premier module d'axe vertical devant être descendu à nouveau, la seconde pile de tranches (13) soulevées dans la seconde position de soulèvement devant être saisie ensuite par la pince à vide multiple (6) du module dos à dos (module BTB) (7) et devant être déplacée sans rotation dans la première position de soulèvement au-dessus de la première pile de tranches de silicium (9), dans laquelle les tranches (1) de la première pile de tranches (9) à soulever par le peigne de soulèvement (5a) du premier module d'axe vertical peuvent être déplacées le long d'une trajectoire de mouvement contrôlée par servocommande en passant devant les tranches (1) attribuées de la seconde pile de tranches (13) et les tranches (1) de la seconde pile de tranches (13) devant être appliquées en même temps que les tranches (1) de la première pile de tranches (9) dos à dos dans le peigne de soulèvement (5a) soulevé du premier module d'axe vertical.

4. Système de manipulation selon la revendication 3, **caractérisé en ce que** la pince à vide multiple (6) du module BTB (7) présente une partie supérieure (18) reliée à son axe vertical et une partie inférieure (19) recevant des peignes à pince aspirants (10), **en ce que** la partie supérieure (18) et la partie inférieure (19) sont reliées par deux éléments de guidage à circulation de billes (20) et sont maintenues par ces éléments pendant un déplacement en alignement précis et **en ce qu'**il est prévu sur la partie supérieure (18) de la pince à vide multiple (6) deux capteurs (21) inductifs, par lesquels, lors de l'abaissement de la pince à vide multiple (6), une pose du côté inférieur (22) des peignes à pince aspirants (10) sur les surfaces avant supérieures des tranches (1) se trouvant dans le support (2) doit être enregistrée et un nouvel abaissement de la pince à vide multiple (6) doit être bloqué avec une temporisation minimale.

5. Système de manipulation selon l'une quelconque des revendications 3 et 4, **caractérisé en ce que** la pince à vide multiple (6) présente deux peignes à pince aspirants (10) comprenant chacun 50 parois de peigne (23), avec lesquelles au total 50 tranches solaires (1) doivent être saisies.

6. Système de manipulation selon la revendication 5, **caractérisé en ce que** les parois de peigne (23) des peignes à pince aspirants (10) de la pince à vides multiples (6), qui délimitent les fentes de logement (24) de chaque peigne à pince aspirant (10) et viennent en prise avec les surfaces latérales (25) des tranches (1), sont conçues sous la forme d'une bordure (26) de type cadre avec des lamelles (27) parallèles entre elles et agencées horizontalement, entre lesquelles est formée à chaque fois une fente d'aspiration (28) orientée en angle par rapport à la paroi de peigne (23), et **en ce que** la surface d'appui de chaque paroi de peigne (23), qui vient en prise avec l'une des surfaces latérales (25) de la tranche (1) qui lui est attribuée, est formée par la surface extérieure (29) de la bordure (26) du type cadre des lamelles (27) et les arêtes avant (30) des lamelles (27), qui se situent dans le même plan vertical dans lequel est disposée la surface extérieure (29) de la bordure (26) de type cadre, la pression de surface de la tranche (1) par unité de surface étant minimisée.
